# EUROPEAN PATENT APPLICATION

(11) **EP 4 766 103 A1**
(43) Date of publication of application: **24.06.2026**
(21) Application number: 25209866.0
(22) Date of filing: 20.10.2025
(51) Int. Cl.: H10F 77/45, H10F 77/30

(54) **SOLAR CELL**

(30) Priority: 20.12.2024 CN 202411898846
(71) Applicant: Zhejiang Jinko Solar Co., Ltd., Haining, Zhejiang 314416 (CN)
(72) Inventor: ZHENG, Peiting, HAINING 314416 (CN); MAO, Jie, HAINING 314416 (CN); WANG, Zhao, HAINING 314416 (CN); YANG, Jie, HAINING 314416 (CN); ZHANG, Xinyu, HAINING 314416 (CN)
(74) Representative: DREISS Patentanwälte PartG mbB

(57) **Abstract**

Provided are a solar cell and a photovoltaic module. The solar cell includes a substrate, a passivation layer and a light-transmitting layer. The passivation layer is located on a side of the passivation layer facing a light-receiving surface. The light-transmitting layer is arranged on a side of the passivation layer away from the substrate. The light-transmitting layer includes an adhesive film layer, light-converting particles, and anti-reflection particles. The light-converting particles and the anti-reflection particles are arranged over the passivation layer through the adhesive film layer. An average diameter of the anti-reflection particles is less than or equal to that of the light-converting particles.

## Description

### TECHNICAL FIELD

The present disclosure relates to the field of photovoltaic devices, and in particular, to a solar cell and a photovoltaic module.

### BACKGROUND

With technological advancements, photovoltaic devices such as photovoltaic modules are increasingly widely used in people's daily lives. The photovoltaic module includes a crystalline silicon solar cell. The crystalline silicon solar cell can absorb light and convert light energy into electrical energy. However, the crystalline silicon solar cell exhibits low ultraviolet responsivity, and has poor absorption to ultraviolet light during operation, resulting in larger optical losses in an ultraviolet band, thereby limiting improvement of short-circuit current and photovoltaic conversion efficiency of the crystalline silicon solar cell. Moreover, the ultraviolet light may damage a passivation structure on the light-receiving surface of the crystalline silicon solar cell, which may lead to efficiency degradation of the crystalline silicon solar cell and affect the service life of the crystalline silicon solar cell.

### SUMMARY

Embodiments of the present disclosure provide a solar cell and a photovoltaic module, to improve efficiency of the solar cell.

Embodiments of the present disclosure provide a solar cell, having a light-receiving surface and a backlight surface, and including: a substrate; a passivation layer; and a light-transmitting layer arranged on a side of the passivation layer.

The passivation layer is located on a side of the substrate facing the light-receiving surface, the light-transmitting layer is arranged on a side of the passivation layer away from the substrate, and the light-transmitting layer includes an adhesive film layer, light-converting particles, and anti-reflection particles, the light-converting particles and the anti-reflection particles are arranged over the passivation layer through the adhesive film layer, and an average diameter of the anti-reflection particles is less than or equal to an average diameter of the light-converting particles.

In one or more embodiments, a diameter of each of the light-converting particles ranges from 20 nanometers to 500 nanometers, and a diameter of each of the anti-reflection particles ranges from 20 nanometers to 300 nanometers.

In one or more embodiments, a refractive index of the light-converting particles ranges from 1.1 to 1.6, and a refractive index of the anti-reflection particles ranges from 1.1 to 1.5.

In one or more embodiments, an excitation wavelength of the light-transmitting layer ranges from 200 nanometers to 500 nanometers, and/or a fluorescence characteristic peak of the light-transmitting layer is within a wavelength range of 400 nanometers to 900 nanometers.

In one or more embodiments, the light-converting particles include at least one of a silicate containing a rare earth element and a sulfide containing a rare earth element; and the anti-reflection particles include a metal oxide, and a band gap of the metal oxide is no less than 1.5 eV

In one or more embodiments, the adhesive film layer is a resin film layer, a thickness of the adhesive film layer ranges from 5 nanometers to 100 nanometers, and/or a refractive index of the adhesive film layer ranges from 1.3 to 1.7.

In one or more embodiments, the light-receiving surface of the solar cell is provided with a first region and a second region, the first region is configured to arrange grid lines, and the light-transmitting layer is arranged in the second region.

In one or more embodiments, in projections along a thickness direction of the solar cell, a total area of the second region is m, a total area of the light-converting particles is n, and a total area of the anti-reflection particles is q, where 0.1 m≤n≤m and 0.4 m≤q≤m.

In one or more embodiments, the total area of the anti-reflection particles is no less than the total area of the light-converting particles.

Embodiments of the present disclosure further provide a photovoltaic module. The photovoltaic module includes a solar cell, and the solar cell is the solar cell in any one of the above embodiments.

Embodiments of the present disclosure provide a solar cell and a photovoltaic module. The solar cell includes a substrate, a passivation layer and a light-transmitting layer. The solar cell has a light-receiving surface and a backlight surface, and along a thickness direction of the solar cell, the light-receiving surface and the backlight surface are located on two opposite sides of the solar cell, the passivation layer is located on a side of the solar cell facing the light-receiving surface, and the light-transmitting layer is located on a side of the passivation layer away from the substrate. The light-transmitting layer includes an adhesive film layer, light-converting particles, and anti-reflection particles, and the light-converting particles and the anti-reflection particles are arranged over the passivation layer through the adhesive film layer. An average diameter of the anti-reflection particles is less than or equal to that of the light-converting particles. The light-converting particles are used to convert ultraviolet light into visible light, and the anti-reflection particles are used to increase light transmittance of the light-transmitting layer. In the solutions provided by the embodiments of the present disclosure, by arranging the light-transmitting layer over the light-receiving surface of the solar cell, ultraviolet light may be converted into visible light by using the light-converting particles, thereby improving utilization of the ultraviolet light by the solar cell, helping increase a short-circuit current and efficiency of the solar cell, and suppressing ultraviolet-induced degradation. Since the ultraviolet light can be converted into visible light through the light-converting particles and then enter the interior of the solar cell, ultraviolet-induced degradation of the solar cell can be reduced, thereby helping prolong the service life of the solar cell and improve efficiency of the solar cell, which is more in line with actual usage requirements. The arrangement of the anti-reflection particles can increase the light transmittance of the light-transmitting layer, thereby reducing optical losses and facilitating the solar cell to better absorb light. The average diameter of the anti-reflection particles is less than that of the light-converting particles, which can help reduce reflection of the light-transmitting layer and improve light absorption efficiency of the solar cell. The light-transmitting layer is arranged on the side of the passivation layer away from the substrate. Therefore, in the solutions provided by the embodiments of the present disclosure, it is not necessary to adjust the structure of the passivation layer, a process flow of the basic structure of the solar cell may remain unadjusted during the processing of the solar cell, and the light-transmitting layer is arranged on a light-receiving side of the solar cell after the processing of the basic structure of the solar cell is completed. Such a design can reduce an influence on the passivation layer, thereby reducing an influence on a passivation reaction.

### BRIEF DESCRIPTION OF DRAWINGS

In order to more clearly illustrate the technical solutions in embodiments of the present disclosure, the accompanying drawings used in the description of the embodiments will be briefly introduced below. It is apparent that, the accompanying drawings in the following description are only some embodiments of the present disclosure, and other drawings can be obtained by those of ordinary skill in the art from the provided drawings without creative efforts.
FIG. 1 is a schematic diagram of a solar cell according to one or more embodiments of the present disclosure;
FIG. 2 is a schematic diagram of a scanning electron microscope (SEM) image of a solar cell according to one or more embodiments of the present disclosure;
FIG. 3 is a schematic diagram of a solar cell according to one or more embodiments of the present disclosure;
FIG. 4 is a diagram of a fluorescence testing spectrum of a solar cell with light-converting particles and a solar cell without a light-transmitting layer according to one or more embodiments of the present disclosure; and
FIG. 5 is a diagram of a fluorescence testing spectrum of a solar cell with light-converting particles and a solar cell with light-converting particles and anti-reflection particles according to one or more embodiments of the present disclosure.

Reference signs: 11-substrate; 12-passivation layer; 13-grid line; 2-light-transmitting layer; 21-adhesive film layer; 22-light-converting particle; 23-anti-reflection particle.

### DESCRIPTION OF EMBODIMENTS

In order to better understand the technical solutions of the present disclosure, the embodiments of the present disclosure are described in detail below with reference to the accompanying drawings.

It should be clear that the described embodiments are only some of rather than all of the embodiments of the present disclosure. All other embodiments obtained by those of ordinary skill in the art without creative efforts based on the embodiments of the present disclosure shall fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

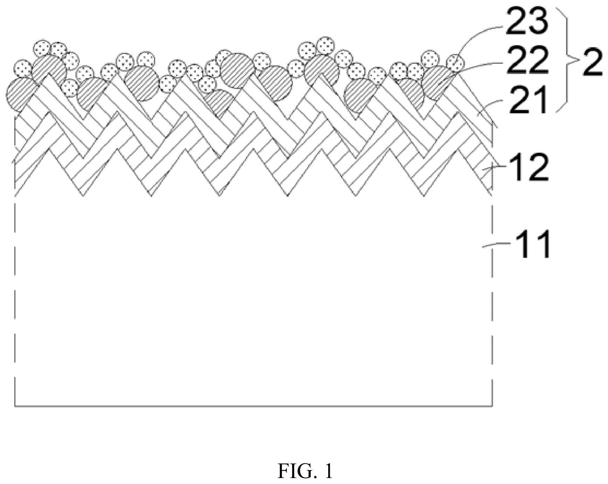

As shown in FIG. 1, embodiments of the present disclosure provide a solar cell. The solar cell includes a substrate 11, a passivation layer 12 and a light-transmitting layer 2. The solar cell includes a light-receiving surface and a backlight surface. Along a thickness direction of the solar cell, the light-receiving surface and the backlight surface are located on two opposite sides of the solar cell. The passivation layer 12 is located on a side of the solar cell facing the light-receiving surface. The light-transmitting layer 2 is located on a side of the passivation layer 12 away from the substrate 11. The light-transmitting layer 2 includes an adhesive film layer 21, light-converting particles 22, and anti-reflection particles 23. The light-converting particles 22 and the anti-reflection particles 23 are arranged over the passivation layer 12 through the adhesive film layer 21. An average diameter of the anti-reflection particles 23 is less than or equal to that of the light-converting particles 22. The light-converting particles 22 are used to convert ultraviolet light into visible light. The anti-reflection particles 23 are used to increase light transmittance of the light-transmitting layer 2.

Affected by low intensity of the ultraviolet light, there are larger optical losses in an ultraviolet band during operation of the crystalline silicon solar cell, which may affect a short-circuit current and conversion efficiency of the solar cell. In addition, the ultraviolet light may damage a passivation structure of the solar cell located over the light-receiving surface, which affects a passivation reaction, resulting in a decrease in efficiency of the solar cell.

In the solutions provided by the embodiments of the present disclosure, by arranging the light-transmitting layer 2 over the light-receiving surface of the solar cell, the light-converting particles 22 of the light-transmitting layer 2 exhibit a photoluminescence phenomenon following Stokes' law, that is, energy of emitted photons is lower than that of absorbed photons, an emission spectrum of the light-converting particles 22 resides on the long-wavelength side of an excitation spectrum, the light-converting particles 22 can absorb highenergy short-wavelength radiation and emit low-energy long-wavelength radiation, thereby converting the ultraviolet light. Therefore, the ultraviolet light may be converted into visible light by using the light-converting particles 22, thereby improving utilization of ultraviolet light by the solar cell, helping increase a short-circuit current and efficiency of the solar cell, and suppressing ultraviolet-induced degradation. Since the ultraviolet light can be converted into visible light through the light-converting particles 22 and then enter the interior of the solar cell, ultraviolet-induced degradation of the solar cell can be reduced, thereby helping prolong the service life of the solar cell and improve efficiency of the solar cell, which is more in line with actual usage requirements. The arrangement of the anti-reflection particles 23 can increase the light transmittance of the light-transmitting layer 2, thereby reducing optical losses and facilitating the solar cell to better absorb light. An optical thickness of the anti-reflection particles 23 is 0.25 λ. The optical thickness refers to total attenuation caused by absorbing and scattering materials per unit cross-sectional area during the calculation of radiation transmission. For vertical incident light with a wavelength of λ, two reflected beams of light interfere destructively, while transmitted beams of light interfere constructively, resulting in minimum reflectivity and maximum light transmittance, thereby enhancing transmissivity. The incident light for the solar cell generally refers to sunlight. The average diameter of the anti-reflection particles 23 is less than that of the light-converting particles 22, which can help reduce reflection of the light-transmitting layer 2 and improve light absorption efficiency of the solar cell. When the average diameter of the anti-reflection particles 23 is greater than that of the light-converting particles 22, the anti-reflection particles 23 may have a reduced anti-reflection effect. Moreover, when the anti-reflection particles 23 have greater diameters, their own optical thicknesses may be affected, resulting in a decrease in the anti-reflection effect.

During measurement of the average diameter of the particles, 10 light-converting particles 22 may be randomly selected from an SEM image, and an average value of diameters may be calculated to obtain the average diameter of the light-converting particles 22. The anti-reflection particles 23 may be calculated in the same manner. 10 anti-reflection particles 23 are selected from the SEM image, and an average value of diameters may be calculated to obtain the average diameter of the anti-reflection particles 23.

The light-transmitting layer 2 is arranged on the side of the passivation layer 12 away from the substrate 11. Therefore, in the solutions provided by the embodiments of the present disclosure, it is not necessary to adjust the structure of the passivation layer 12, a process flow of the basic structure of the solar cell may remain unadjusted during the processing of the solar cell, and the light-transmitting layer 2 is arranged on a light-receiving side of the solar cell after the processing of the basic structure of the solar cell is completed. Such a design can reduce an influence on the passivation layer 12, thereby reducing an influence on a passivation reaction.

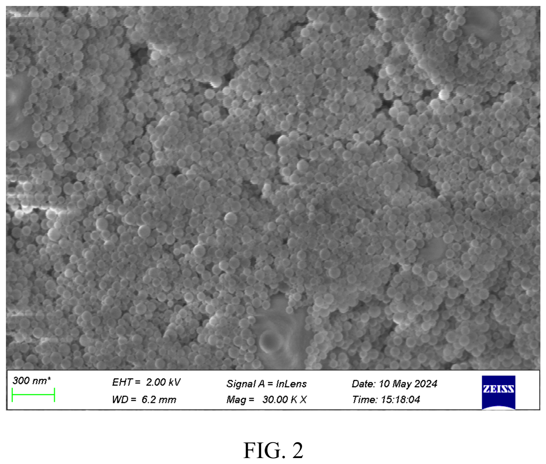

FIG. 2 shows an SEM image of a solar cell according to one or more embodiments of the present disclosure. In one or more embodiments, a diameter of each of the light-converting particles 22 ranges from 20 nanometers to 500 nanometers, and a diameter of each of the anti-reflection particles 23 ranges from 20 nanometers to 300 nanometers. The diameter of the light-converting particle 22 may be 20 nanometers, 60 nanometers, 100 nanometers, 140 nanometers, 180 nanometers, 220 nanometers, 260 nanometers, 300 nanometers, 340 nanometers, 380 nanometers, 420 nanometers, 460 nanometers, 500 nanometers, or the like. The diameter of the anti-reflection particle 23 may be 20 nanometers, 40 nanometers, 60 nanometers, 80 nanometers, 100 nanometers, 120 nanometers, 140 nanometers, 160 nanometers, 180 nanometers, 200 nanometers, 220 nanometers, 240 nanometers, 260 nanometers, 280 nanometers, 300 nanometers, or the like.

When the diameter of the light-converting particle 22 is less than 20 nanometers, the diameter of the light-converting particle 22 is excessively small, which easily causes uneven distribution of the light-converting particles 22 during the arrangement, thereby affecting conversion efficiency of the light-transmitting layer 2 for the ultraviolet light. When the diameter of the light-converting particle 22 is greater than 500 nanometers, the processing difficulty may be increased, thereby affecting processing efficiency. When the diameter of the anti-reflection particle 23 is less than 20 nanometers, the diameter of the anti-reflection particle 23 is excessively small, which may cause an increase in manufacturing difficulty and easily cause uneven distribution of the anti-reflection particles 23 during the arrangement of the anti-reflection particles 23. When the diameter of the anti-reflection particle 23 is greater than 300 nanometers, the diameter of the anti-reflection particle 23 is excessively large, which may degrade anti-reflective performance of the anti-reflection particles 23, thereby affecting light transmittance of the light-transmitting layer 2.

In one or more embodiments, a refractive index of the light-converting particles 22 ranges from 1.1 to 1.6, and a refractive index of the anti-reflection particles 23 ranges from 1.1 to 1.5. The refractive index of the light-converting particles 22 may be 1.1, 1.2, 1.3, 1.4, 1.5, 1.6, or the like. The refractive index of the anti-reflection particles 23 may be 1.1, 1.2, 1.3, 1.4, 1.5, or the like.

When the refractive index of the light-converting particles 22 is less than 1.1 and the refractive index of the anti-reflection particles is less than 1.1, an overall refractive index of the light-transmitting layer 2 is relatively low, and material preparation is relatively difficult, which may lead to increased costs. When the refractive index of the light-converting particles 22 is greater than 1.6 and the refractive index of the anti-reflection particles 23 is greater than 1.5, the overall refractive index of the light-transmitting layer 2 is relatively high, which affects a transfer rate of light in the light-transmitting layer 2 and leads to increased optical losses. Moreover, as the refractive index increases, reflectivity of the light-transmitting layer 2 may increase. As a result, part of the light is reflected by the light-transmitting layer 2 and cannot be transferred to the interior of the solar cell, thereby affecting conversion efficiency of the solar cell.

In one or more embodiments, an excitation wavelength of the light-transmitting layer 2 ranges from 200 nanometers to 500 nanometers, and/or a fluorescence characteristic peak of the light-transmitting layer 2 is within a wavelength range of 400 nanometers to 900 nanometers.

The excitation wavelength of the light-transmitting layer 2 ranges from 200 nanometers to 500 nanometers, and the excitation wavelength can include a wavelength range of the ultraviolet light, so that the light-transmitting layer 2 can convert the ultraviolet light into visible light, thereby improving light absorption efficiency of the solar cell and reducing damage of the ultraviolet light to the passivation layer 12, which helps prolong the service life of the solar cell and improve conversion efficiency. The solar cell has high absorption efficiency for the visible light, but low absorption efficiency for the ultraviolet light. Therefore, the ultraviolet light is converted by the light-transmitting layer 2, and the fluorescence characteristic peak is within a wavelength range of 400 nanometers to 900 nanometers, indicating that the light-transmitting layer 2 can emit visible and near-infrared light. Therefore, the light-transmitting layer 2 can convert the ultraviolet light into the visible light, thereby increasing an overall light absorption rate of the solar cell and further improving the efficiency of the solar cell.

In one or more embodiments, the light-converting particles 22 include at least one of a silicate containing a rare earth element and a sulfide containing a rare earth element. The rare earth element includes, but is not limited to, europium (Eu), dysprosium (Dy), and the like. The light-converting particle 22 may be MgSiO₃: Eu²⁺, Dy³⁺, and CdS quantum dots. The anti-reflection particle 23 may be a metal oxide with a wide band gap, such as a magnesium oxide and an aluminum oxide. The band gap of the metal oxide is no less than 1.5 eV.

With such a design, the ultraviolet light can be converted by the light-converting particles 22, thereby reducing a possibility of damage to the passivation layer 12 of the solar cell and improving conversion efficiency of the solar cell. When the band gap of the metal oxide is less than 1.5 eV, the anti-reflection particles 23 have low utilization for light, which may affect photoelectric conversion efficiency of the solar cell.

In one or more embodiments, the adhesive film layer 21 is a resin film layer, a thickness of the resin film layer ranges from 5 nanometers to 100 nanometers, and/or a refractive index of the adhesive film layer 21 ranges from 1.3 to 1.7. The thickness of the adhesive film layer 21 may be 5 nanometers, 10 nanometers, 20 nanometers, 30 nanometers, 40 nanometers, 50 nanometers, 60 nanometers, 70 nanometers, 80 nanometers, 90 nanometers, 100 nanometers, or the like. The refractive index of the adhesive film layer 21 may be 1.3, 1.4, 1.5, 1.6, 1.7, or the like.

When the thickness of the adhesive film layer 21 is less than 5 nanometers, the adhesive film layer 21 is excessively thin and exhibits an insufficient bonding capability, the light-converting particles 22 and the anti-reflection particles 23 are easy to fall off, and the light-transmitting layer 2 has poor stability. When the thickness of the adhesive film layer 21 is greater than 100 nanometers, the adhesive film layer 21 is excessively thick, and a transfer distance of light in the adhesive film layer 21 is excessively long, which leads to increased optical losses during the transfer and affects conversion efficiency of the solar cell. When the refractive index of the adhesive film layer 21 is less than 1.3, the refractive index of the adhesive film layer 21 is excessively small, which places a high requirement on the material and makes the preparation excessively difficult, thereby increasing the costs and affecting production efficiency. When the refractive index of the adhesive film layer 21 is greater than 1.7, transfer efficiency of light in the adhesive film layer 21 may be affected, which increases the losses of light during the transfer, thereby affecting the conversion efficiency of the solar cell.

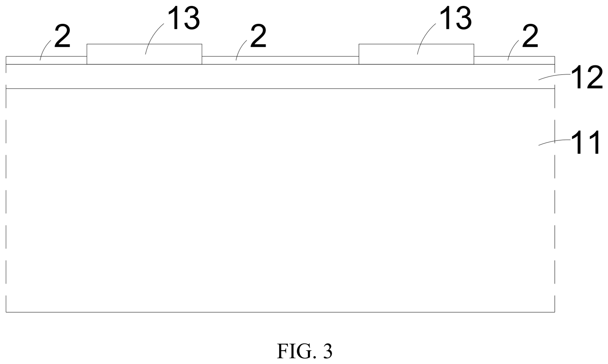

As shown in FIG. 3, in one or more embodiments, the light-receiving surface of the solar cell is provided with a first region and a second region. The first region is used to arrange grid lines 13. The light-transmitting layer 2 is arranged in the second region.

Such a design can reduce an influence of the light-transmitting layer 2 on the grid line 13. When the light-transmitting layer 2 is arranged in the first region, a surface of the grid lines 13 may be covered, which affects contact performance of the grid lines 13, thereby affecting the operating state of the solar cell.

In one or more embodiments, a width of the first region may be greater than that of the grid lines 13. Such a design can ensure a certain spacing between the light-transmitting layer 2 and the grid lines 13, thereby reducing a possibility of the light-transmitting layer 2 covering the grid lines 13, reducing processing difficulty, and reducing an influence of the light-transmitting layer 2 on the grid lines 13.

During the manufacturing of the solar cell, the light-converting particles 22 and the anti-reflection particles 23 may be added to resin materials, respectively. After the processing of the basic structure of the solar cell is completed, the resin materials having the light-converting particles 22 may be first arranged on a side of the passivation layer 12 where the light-receiving surface is located, and then the resin materials having the anti-reflection particles 23 may be arranged on the side of the passivation layer 12 where the light-receiving surface is located. Such a design can facilitate arrangement of the anti-reflection particles 23 on a side of the light-converting particles 22 away from the passivation layer 12. Such a design helps increase light transmittance of the light-transmitting layer 2, thereby improving absorption efficiency and conversion efficiency of the solar cell.

In one or more embodiments, in projections along a thickness direction of the solar cell, a total area of the second region is m, a total area of the light-converting particles 22 is n, and a total area of the anti-reflection particles 23 is q, where m, n, and q satisfy 0.1 m≤n≤m and 0.4 m≤q≤m. The light-converting particles 22 account for 10% to 100% of the area of the second region, and the anti-reflection particles 23 account for 40% to 100% of the area of the second region. The light-converting particles 22 may account for 10%, 20%, 30%, 40%, 50%, 60%, 70%, 80%, 90%, 100%, or the like of the area of the second region. The anti-reflection particles 23 may account for 40%, 50%, 60%, 70%, 80%, 90%, 100%, or the like of the area of the second region.

When the light-converting particles 22 account for less than 10% of the area of the second region, the light-converting particles 22 have an excessively small area, which has low conversion efficiency for the ultraviolet light and has a minor effect on efficiency improvement of the solar cell. When the anti-reflection particles 23 account for less than 40% of the area of the second region, the anti-reflection particles 23 have an excessively small area, which has a minor effect on improvement of light transmittance of the light-transmitting layer 2 and has small improvement in efficiency of the solar cell.

In one or more embodiments, the total area of the anti-reflection particles 23 is no less than the total area of the light-converting particles 22.

Such a design helps increase light transmittance of the light-transmitting layer 2, so that more light can enter the light-transmitting layer 2 and be converted by the light-converting particles 22. When the total area of the anti-reflection particles 23 is smaller than the total area of the light-converting particles 22, less light may enter the light-transmitting layer 2, resulting in lower utilization of the light-converting particles 22 and affecting the conversion efficiency of the solar cell.

In the solutions provided by the embodiments of the present disclosure, by arranging the light-transmitting layer 2 including the light-converting particles 22 and the anti-reflection particles 23 over a front surface of the solar cell, the ultraviolet light in the light can be converted into visible light. This can improve light absorption efficiency of the solar cell and reduce ultraviolet degradation and reducing damage of the ultraviolet light to the passivation layer 12, thereby helping prolong the service life of the solar cell and reduce an influence of the ultraviolet degradation on efficiency.

After the processing of the basic structure of the solar cell is completed, the light-transmitting layer 2 may be arranged, by spin coating, spray coating, scraping coating, or the like, on a side where the light-receiving surface of the solar cell is located. Such a design does not require adjustment of the processing process of the basic structure of the solar cell. After the processing of the basic structure of the solar cell is completed, a process of coating the light-transmitting layer 2 is added, and production difficulty is relatively low. When the light-transmitting layer 2 is arranged, the grid lines 13 may be shielded to reduce a possibility of arrangement of the light-transmitting layer 2 in the first region.

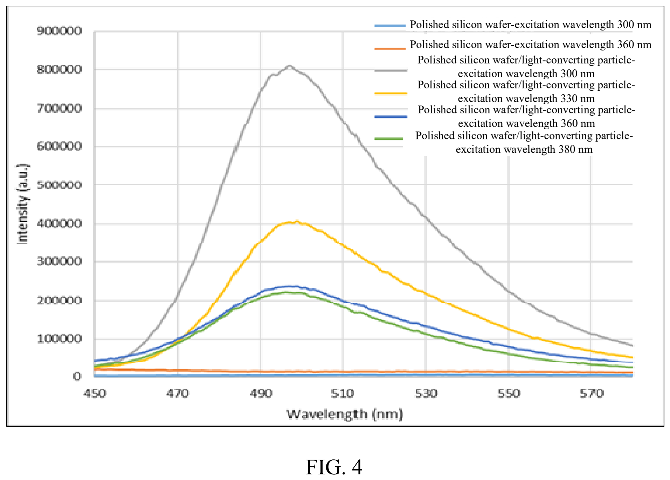

In one or more embodiments, the light-transmitting layer 2 may include an adhesive layer and light-converting particles 22, and the light-converting particles 22 include, but are not limited to, a silicate or a sulfide containing a rare earth element. The rare earth element includes, but is not limited to, Eu, Dy, and the like. As shown in FIG. 4, in which the horizontal axis represents wavelengths of emitted light, and the vertical axis represents fluorescence signal intensity. A polished silicon wafer is a solar cell without light-converting particles 22, and the polished silicon wafer/light -converting particles 22 is a solar cell with a light-transmitting layer 2 having light-converting particles 22 arranged over the passivation layer 12. The curves in FIG. 4 are fluorescence signal intensity under different excitation wavelengths in various solutions. As can be clearly seen from FIG. 4, the fluorescence signal intensity of solutions with the light-converting particles 22 provided by the embodiments of the present disclosure is significantly higher than that of the solutions without the light-converting particles 22. In addition, no fluorescence characteristic peak appears in the curve of the solutions without the light-converting particles 22. That is, the solutions without the light-converting particles 22 cannot convert ultraviolet light, while the solutions with the light-converting particles 22 can convert the ultraviolet light into visible light through the light-converting particles 22, thereby facilitating the solar cell to absorb light.

Taking a tunnel oxide passivated contact (TOPCon) solar cell as an example, data in Table 1 and Table 2 below is obtained by testing the TOPCon solar cell.

**Table 1**

| TOPCon solar cell | Voc (V) | Isc (A) | FF (%) | Eta (%) |
|---|---|---|---|---|
| Prior to coating light-converting particles | 0.7354 | 13.866 | 85.15 | 25.93 |
| Subsequent to coating light-converting particles | 0.7356 | 13.927 | 85.16 | 26.06 |

**Table 2**

| TOPCon solar cell | Initial Voc (V) | When UV irradiation reaches 15 kWh, Voc (V) | Attenuation magnitude |
|---|---|---|---|
| Prior to coating light-converting particles | 0.7354 | 0.7285 | -0.94% |
| Subsequent to coating light-converting particles | 0.7356 | 0.7309 | -0.64% |

In the tables, Voc denotes an open-circuit voltage, Isc denotes a short-circuit current, FF denotes a fill factor, and Eta denotes efficiency. When UV irradiation reaches 15 kWh means that when a total irradiation amount of ultraviolet lamp irradiating the solar cell is 15 kWh.

As can be seen from Table 1 and Table 2 above, by arranging the light-transmitting layer 2 having the light-converting particles 22 over the light-receiving surface of the TOPCon solar cell, the short-circuit current of the TOPCon solar cell can be increased by 61 mA and conversion efficiency can be increased by 0.13%, and the UV-induced degradation (UVID) is reduced by 0.3%.

It is to be noted herein that, the solutions provided by the embodiments of the present disclosure can be applied not only to crystalline silicon solar cells, but also to other solar cells such as perovskite stacked solar cells, back contact solar cells, passivated emitter and rear contact (PERC) solar cells, and heterojunction (HIT) solar cells, having the same corresponding effect.

According to actual test results, it can be known that by arranging the light-transmitting layer 2 on a light-receiving side of the TOPCon solar cell, the short-circuit current and conversion efficiency of the TOPCon solar cell can be improved, and ultraviolet degradation can be reduced. Therefore, when conversion efficiency of the solar cell is improved, damage of the ultraviolet light to the passivation layer 12 can also be reduced, thereby helping prolong the service life of the solar cell.

In the solutions provided by the embodiments of the present disclosure, since the processing process of the basic structure of the solar cell is not changed, the grid lines 13 are first arranged over the passivation layer 12 and then the light-transmitting layer 2 is arranged. Since high-temperature sintering and other operations are required during the arrangement of the grid lines 13, in the solutions of first arranging the light-transmitting layer and then arranging the grid lines 13, the light-transmitting layer 2 may be affected by a high temperature when the grid lines 13 are arranged, causing the structure of the light-transmitting layer 2 to be changed or damaged, thereby affecting the performance of the light-transmitting layer 2.

The light-converting particles 22 can be used to convert ultraviolet light. The anti-reflection particles 23 in the light-transmitting layer 2 can be used to increase light transmittance, thereby helping improve conversion efficiency of the light-transmitting layer 2.

The diameter of the anti-reflection particle 23 may not exceed the diameter of the light-converting particle 22, the refractive index of the anti-reflection particles 23 may not exceed the refractive index of the light-converting particles 22, and an area ratio of the anti-reflection particles 23 may be no less than that of the light-converting particles 22.

By controlling the diameters, the refractive indexes, and the area ratios of the anti-reflection particles 23 and the light-converting particles 22, performance of the light-transmitting layer 2 can be adjusted so that the light-transmitting layer 2 has good light transmittance and also has a higher ultraviolet light conversion rate.

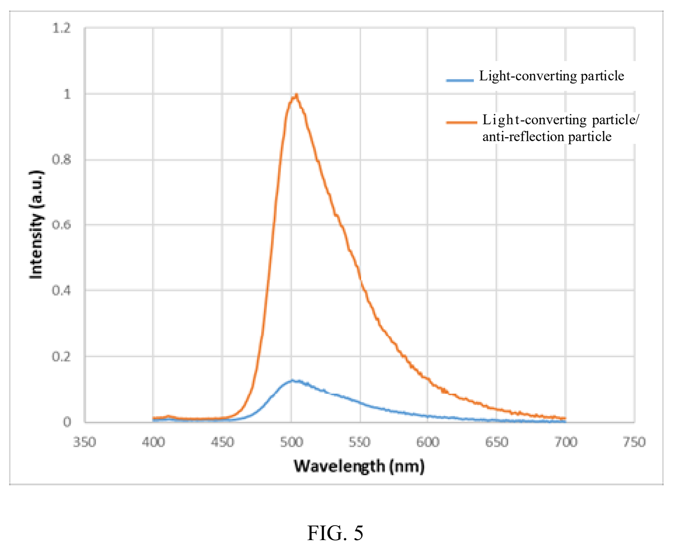

As shown in FIG. 5, in one or more embodiments, in which the horizontal axis represents wavelengths of emitted light, and the vertical axis represents fluorescence signal intensity. The solar cell with the light-transmitting layer 2 can show a fluorescence characteristic peak when illuminated. This indicates that by arranging the light-transmitting layer 2, the ultraviolet light can be converted into visible light. When the solar cell cannot convert the ultraviolet light, no fluorescence characteristic peak may appear in the fluorescence testing spectrum.

The fluorescence characteristic peak appears within a wavelength range of 400 nanometers to 900 nanometers, and the excitation wavelength of the light-converting particles 22 is within a range of 200 to 500 nanometers. Therefore, the ultraviolet light can be converted by the light-converting particles 22, with better conversion efficiency.

The two curves in FIG. 5 are respectively a fluorescence spectrum curve when only the light-converting particles 22 are added to the light-transmitting layer 2 and a fluorescence spectrum curve when both the light-converting particles 22 and the anti-reflection particles 23 are added to the light-transmitting layer 2. By comparison, it can be found that by adding the light-converting particles 22 to the light-transmitting layer 2, a fluorescence characteristic peak can be generated, that is, the ultraviolet light can be converted into visible light. After the light-converting particles 22 and the anti-reflection particles 23 are simultaneously added to the light-transmitting layer 2, fluorescence spectrum signal intensity obtained is 5 to 10 times the fluorescence spectrum signal intensity in the solution without addition of the anti-reflection particles 23.

In the solutions provided by the embodiments of the present disclosure, a thickness of the solar cell ranges from 50 microns to 300 microns. The thickness of the solar cell may be 50 microns, 70 microns, 90 microns, 110 microns, 130 microns, 150 microns, 170 microns, 190 microns, 210 microns, 230 microns, 250 microns, 270 microns, 290 microns, 300 microns, or the like. The solar cell may be a TOPCon solar cell, or the like.

In the solutions provided by the embodiments of the present disclosure, the light-transmitting layer 2 is arranged in the second region of the solar cell, the thickness of the adhesive film layer 21, the diameter of the light-converting particle 22, and the diameter of the anti-reflection particle 23 is all in a nanometer level, and the thickness of the grid lines 13 is in a micrometer level. Therefore, the arrangement of the light-transmitting layer 2 in the second region of the solar cell has little effect on the thickness of the solar cell. In the solutions provided by the embodiments of the present disclosure, without increasing the thickness of the solar cell, the ultraviolet light can be converted by the light-transmitting layer 2 and the light transmittance can be increased by the anti-reflection particles 23, thereby improving the efficiency of the solar cell.

Based on the solar cells provided by the above embodiments, embodiments of the present disclosure further provide a photovoltaic module. The photovoltaic module includes a solar cell. The solar cell may be the solar cell as referred to in any one of the above embodiments. Since the solar cell has the above technical effect, the photovoltaic module including the solar cell also has the corresponding technical effect. Details are not described herein.

The photovoltaic module may include a cover plate, a first adhesive film, a solar cell string, a second adhesive film, and a back plate from top to bottom in a thickness direction. The solar cell string may be formed by connecting a plurality of solar cells in series and/or in parallel.

Based on the solar cells provided by the above embodiments, embodiments of the present disclosure further provide a tandem solar cell. The tandem solar cell includes a bottom solar cell, a top solar cell, and an intermediate connection layer. The bottom solar cell is the solar cell in any of the above embodiments. The top solar cell is one of a perovskite solar cell, a donor-acceptor cell, a cadmium telluride (CdTe) solar cell, a copper indium gallium selenide (CIGS) solar cell, or a gallium arsenide (GaAs) solar cell. The intermediate connection layer is connected between the bottom solar cell and the top solar cell. Since the bottom solar cell has the above-mentioned technical effects, the tandem solar cell including the bottom solar cell should also have the above-mentioned technical effects, which will not be repeated here.

Embodiments of the present disclosure provide a solar cell and a photovoltaic module. The solar cell includes a substrate 11, a passivation layer 12 and a light-transmitting layer 2. The passivation layer 12 is arranged on a side of the substrate 11 facing a light-receiving surface of the solar cell. The light-transmitting layer 2 is arranged on a side of the passivation layer 12 away from the substrate 11. That is, the light-transmitting layer 2 is arranged on a side where the light-receiving surface of the solar cell is located. The light-transmitting layer 2 includes an adhesive film layer 21, light-converting particles 22, and anti-reflection particles 23, the light-converting particles 22 and the anti-reflection particles 23 are arranged over the passivation layer 12 through the adhesive film layer 21, and an average diameter of the anti-reflection particles 23 is less than or equal to that of the light-converting particles 22. The light-converting particles 22 are used to convert ultraviolet light into visible light, and the anti-reflection particles 23 are used to increase light transmittance of the light-transmitting layer 2, thereby helping improve conversion efficiency of the light-converting particles 22. According to such a design, the ultraviolet light in the light can be converted, which facilitates the solar cell to absorb the light, thereby reducing optical losses and further improving the conversion efficiency of the solar cell. The average diameter of the anti-reflection particles 23 is less than that of the light-converting particles 22, which can help reduce reflection of the light-transmitting layer 2 and increase light transmittance of the light-transmitting layer 2, being more in line with actual usage requirements.

The structure, features and effects of the present disclosure are described in detail above according to the embodiments shown in the drawings. The above are only preferred embodiments of the present disclosure, but the present disclosure does not limit the scope of implementation as illustrated in the drawings. Any changes made in accordance with the conception of the present disclosure, or equivalent embodiments modified as equivalent changes, which still do not exceed the spirit covered by the specification and the drawings, shall fall within the protection scope of the present disclosure.

## Claims

1. A solar cell, having a light-receiving surface and a backlight surface, wherein the solar cell comprises:
a substrate (11);
a passivation layer (12); and
a light-transmitting layer (2) arranged on a side of the passivation layer (12),
wherein the passivation layer (12) is located on a side of the substrate (11) facing the light-receiving surface, the light-transmitting layer (2) is arranged on a side of the passivation layer (12) away from the substrate (11), the light-transmitting layer (2) comprises an adhesive film layer (21), light-converting particles (22), and anti-reflection particles (23), the light-converting particles (22) and the anti-reflection particles (23) are arranged over the passivation layer (12) through the adhesive film layer (21), and an average diameter of the anti-reflection particles is less than or equal to an average diameter of the light-converting particles (22).

2. The solar cell according to claim 1, wherein a diameter of the light-converting particles (22) ranges from 20 nanometers to 500 nanometers, and a diameter of the anti-reflection particles (23) ranges from 20 nanometers to 300 nanometers.

3. The solar cell according to claim 1, wherein a refractive index of the light-converting particles (22) ranges from 1.1 to 1.6, and a refractive index of the anti-reflection particles (23) ranges from 1.1 to 1.5.

4. The solar cell according to claim 1, wherein an excitation wavelength of the light-transmitting layer (2) ranges from 200 nanometers to 500 nanometers, and/or a fluorescence characteristic peak of the light-transmitting layer (2) is within a wavelength range of 400 nanometers to 900 nanometers.

5. The solar cell according to claim 1, wherein the light-converting particles (22) comprise at least one of a silicate containing a rare earth element and a sulfide containing a rare earth element; and
the anti-reflection particles (23) comprise a metal oxide, and a band gap of the metal oxide is not less than 1.5 eV.

6. The solar cell according to claim 1, wherein the adhesive film layer (21) is a resin film layer, a thickness of the adhesive film layer ranges from 5 nanometers to 100 nanometers, and/or a refractive index of the adhesive film layer (21) ranges from 1.3 to 1.7.

7. The solar cell according to any one of claims 1 to 6, wherein the light-receiving surface of the solar cell is provided with a first region and a second region, the first region is configured to arrange grid lines (13), and the light-transmitting layer (2) is arranged in the second region.

8. The solar cell according to claim 7, wherein along a thickness direction of the solar cell, a total area of a projection of the second region is m, a total area of a projection of the light-converting particles (22) is n, and a total area of a projection of the anti-reflection particles (23) is q, wherein 0.1 m≤n≤m and 0.4 m≤q≤m.

9. The solar cell according to claim 8, wherein the total area of the projection of the anti-reflection particles (23) is not less than the total area of the projection of the light-converting particles (22).

10. The solar cell according to any one of claims 1 to 9, wherein the light-converting particles are configured to convert ultraviolet light into visible light, and the anti-reflection particles (23) are configured to increase light transmittance of the light-transmitting layer (2).

11. The solar cell according to any one of claims 1 to 10, wherein an optical thickness of the anti-reflection particles (23) is 0.25 λ.

12. The solar cell according to any one of claims 1 to 11, wherein a refractive index of the anti-reflection particles (23) is exceed a refractive index of the light-converting particles.

13. The solar cell according to any one of claims 1 to 12, wherein a thickness of the solar cell ranges from 50 microns to 300 microns.

14. A photovoltaic module, wherein the photovoltaic module comprises a solar cell, and the solar cell is the solar cell according to any one of claims 1 to 13.

15. A tandem solar cell, comprising:
a top solar cell;
a bottom solar cell; and
an intermediate connection layer connected between the bottom solar cell and the top solar cell;
wherein the top solar cell is a perovskite solar cell, and the bottom solar cell is the solar cell according to any one of claims 1 to 13.
